Europäisches Patentamt

European Patent Office

Office européen des brevets

(19)

(11) Veröffentlichungsnummer: **0 288 921 B1**

## (12) EUROPÄISCHE PATENTSCHRIFT

(45) Veröffentlichungstag der Patentschrift: **07.08.91**

(51) Int. Cl.5: **H03K 17/95**

(21) Anmeldenummer: **88106475.2**

(22) Anmeldetag: **22.04.88**

(54) **Induktiver Näherungsschalter.**

(30) Priorität: **30.04.87 DE 3714433**

(43) Veröffentlichungstag der Anmeldung:
**02.11.88 Patentblatt 88/44**

(45) Bekanntmachung des Hinweises auf die
Patenterteilung:
**07.08.91 Patentblatt 91/32**

(84) Benannte Vertragsstaaten:
**AT BE CH DE ES FR GB IT LI NL SE**

(56) Entgegenhaltungen:
**DE-B- 1 302 191**
**FR-A- 1 344 681**
**US-A- 3 896 371**

(73) Patentinhaber: **Werner Turck GmbH & Co. KG**
**Goethestrasse 7**
**W-5884 Halver(DE)**

(72) Erfinder: **Tigges, Burkhard**
**Zur Rieke 1**
**W-5768 Sundern(DE)**
Erfinder: **Brasse, Dierk**
**Bussardweg 11**
**W-5885 Schalksmühle(DE)**

(74) Vertreter: **Peerbooms, Rudolf, Dipl.-Phys.**
**Postfach 200 208 Dickmannstrasse 45c**
**W-5600 Wuppertal 2(DE)**

## Beschreibung

Die Erfindung betrifft einen induktiven Näherungsschalter, der aus einer Oszillatorschaltung mit einem im wesentlichen die Frequenz bestimmenden Frequenz-Schwingkreis und mit einem im wesentlichen die Verstärkung bestimmenden Impedanzglied, welches einen Impedanz-Schwingkreis mit einer durch die Annäherung eines metallischen Auslösers beeinflußbaren Sensorspule enthält, und aus einer Auswerteschaltung besteht, die die Schaltzustände des Näherungsschalters aus dem Schwingungszustand, bzw. der Schwingungsamplitude, ableitet, wobei bei einem kritischen, dem Schaltabstand des Auslösers zugeordneten Impedanzwert des Impedanz-Gliedes, d. h bei einem kritischen Verstärkungsfaktor, der Schwingungszustand des Oszillators wechselt.

Bei den üblichen, bekannten Näherungsschaltern (DE-PS 28 27 951) liegt die Sensorspule in dem die Frequenz des Oszillators bestimmenden Schwingkreis. Bei solchen Näherungsschaltern ist die Ansprechempfindlichkeit auf Nichteisen-Metalle wie Aluminium, Kupfer, im folgenden NF-Metalle genannt, unterschiedlich gegenüber der Ansprechempfindlichkeit auf Eisen-Metalle oder ferromagnetische Metalle, im folgenden FE-Metalle genannt. Daraus ergeben sich unterschiedliche Schaltabstände für die jeweiligen Auslöser-Metalle, weshalb in der Praxis für die verschiedenen Materialien gesonderte Näherungsschalter hergestellt werden müssen, falls diese übereinstimmenden Schaltabstand haben sollen.

Ferner sind induktive Näherungsschalter bekannt (Prospekt "Näherungsschalter 1 H 1", Ausgabe 11/82, der Fa. Hans Turck GmbH & Co. KG, Mülheim/Ruhr), bei denen die Oszillatorschaltung außer dem die Frequenz bestimmenden, von außen unbeeinflußbaren Schwingkreis noch einen weiteren Serienschwingkreis aufweist, welcher als Impedanzglied der Oszillatorschaltung geschaltet ist und dessen induktives Glied von der durch einen Auslöser beeinflußbaren Sensorspule gebildet wird. Bei diesem gattungsgemäßen Näherungsschalter wird durch die Annäherung eines metallischen Auslösers der Impedanzwert und damit der Verstärkungsfaktor der Oszillatorschaltung verändert, und zwar ist dieser Näherungsschalter so ausgelegt, daß bei dem gewünschten Schaltabstand die kritische Impedanz bzw. der kritische Verstärkungsfaktor überschritten wird, bei dem der Schwingungszustand der Oszillatorschaltung wechselt. Ein ähnlicher Näherungsschalter ist im übrigen auch in FR-A-1 344 681 beschrieben. Bei diesen bekannten Näherungsschaltern wird die unterschiedliche Ansprechempfindlichkeit auf FE-oder NF-Metalle zur Herstellung von sogenannten selektiven Näherungsschaltern ausgenützt, die also jeweils nur entweder auf FE- oder NF-Metall ansprechen. Beim Einsatz solcher Näherungsschalter ist es also möglich, auf einem Fließband gemischt vorbeilaufende Aluminium- und Eisendosen getrennt zu zählen.

Der Erfindung liegt die Aufgabe zugrunde, einen induktiven Näherungsschalter zu schaffen, der sowohl FE-als auch NF-Metalle mit im wesentlichen gleicher Ansprechempfindlichkeit erkennt und in beiden Fällen denselben Schaltabstand aufweist.

Ausgehend von einem gattungsgemäßen Näherungsschalter wird diese Aufgabe erfindungsgemäß dadurch gelöst, daß die Resonanz-Frequenz des Frequenz-Schwingkreises und der kritische Impedanzwert des Impedanzgliedes den Koordinaten des Schnittpunktes der beiden Impedanz/Frequenz-Kennlinien entsprechen, die das Impedanzglied für NF- und FE-Metalle bei jeweils gleichem Schaltabstand aufweist.

Die Erfindung geht von der Erkenntnis aus, daß insbesondere bei Schwingkreisen von hoher Güte, z. B. 100 oder mehr, sich die Impedanz/Frequenz-Kennlinien für im gewünschten Schaltabstand sich befindende NF- und FE-Auslöser schneiden. Diesem Schnittpunkt sind eine bestimmte Frequenz und eine bestimmte Impedanz zugeordnet. Der Erfindung zufolge wird nunmehr die Eigenfrequenz des frequenzbestimmenden Frequenz-Schwingkreises auf diesen Frequenzwert einjustiert. Sodann wird die kritische Impedanz der Oszillatorschaltung auf den Impedanzwert dieses Schnittpunktes eingestellt, wozu ein gesondertes Verstellglied im Impedanzzweig der Oszillatorschaltung vorgesehen werden kann. In der Praxis kann man allerdings auch einen Impedanz-Schwingkreis verwenden, dessen Impedanz im Schnittpunkt von Hause aus der kritischen Impedanz der Oszillatorschaltung entspricht, so daß eine nachträgliche Einstellung nicht mehr erforderlich ist.

Liegt der Schnittpunkt, - bezogen auf die Impedanz/Frequenz-Kennlinie bei unbeeinflußtem Schwingkreis -, in dessen nichtschwingenden Bereich, ergibt sich nach der Erfindung ein Näherungsschalter, der in unbeeinflußtem Zustand nicht schwingt und der sowohl bei Annäherung eines NF- als auch eines FE-Auslösers auf einen bestimmten Schaltabstand anschwingt. Liegt dagegen der ermittelte Schnittpunkt, - wiederum bezogen auf die Kennlinie des nicht beeinflußten Schwingkreises -, außerhalb des nichtschwingenden Bereiches, ergibt sich nach der Erfindung ein Näherungsschalter, dessen Oszillator in unbeeinflußtem Zustand schwingt und der durch Annäherung des NF- oder FE-Auslösers überkritisch bedämpft wird.

Nach weiteren Merkmalen der Erfindung können der Frequenz-Schwingkreis und der Impedanz-Schwingkreis vorteilhafterweise aus gleichen Bauteilen bestehen und können die Schwingkreise mechanisch identisch ausgeführt sein. Hierdurch wird

2

ein übereinstimmendes Verhalten bei Temperaturänderungen sichergestellt.

Weitere Merkmale der Erfindung sind in den Unteransprüchen angegeben und werden nachfolgend anhand mehrerer in der Zeichnung dargestellter Ausführungsbeispiele näher erläutert. In der Zeichnung zeigen:

Fig 1    die Oszillatorschaltung eines Näherungsschalters gemäß einer ersten Ausführungsform der Erfindung,

Fig. 2    ein Diagramm zur Erläuterung der Kennlinien des Impedanzgliedes der Oszillatorschaltung nach Fig. 1, bezogen auf einen ersten gewünschten Schaltabstand,

Fig 3    ein Diagramm analog zu Fig. 2, jedoch bezogen auf einen zweiten Schaltabstand,

Fig 4    eine abgewandelte Ausführungsform für den frequenzbestimmenden Schwingkreis bei der Schaltung nach Fig. 1,

Fig. 5    eine Abwandlungsform für den Impedanz-Schwingkreis nach Fig. 1,

Fig. 6    eine weitere Ausführungsform einer Oszillatorschaltung eines Näherungsschalters nach der Erfindung,

Fig. 7    eine schematische, gegenständliche Darstellung der Spulen der beiden Schwingkreise nach Fig. 1 und

Fig. 8    eine gegenüber Fig. 7 abgewandelte, gegenständliche Darstellung der Spulenanordnung nach Fig. 1.

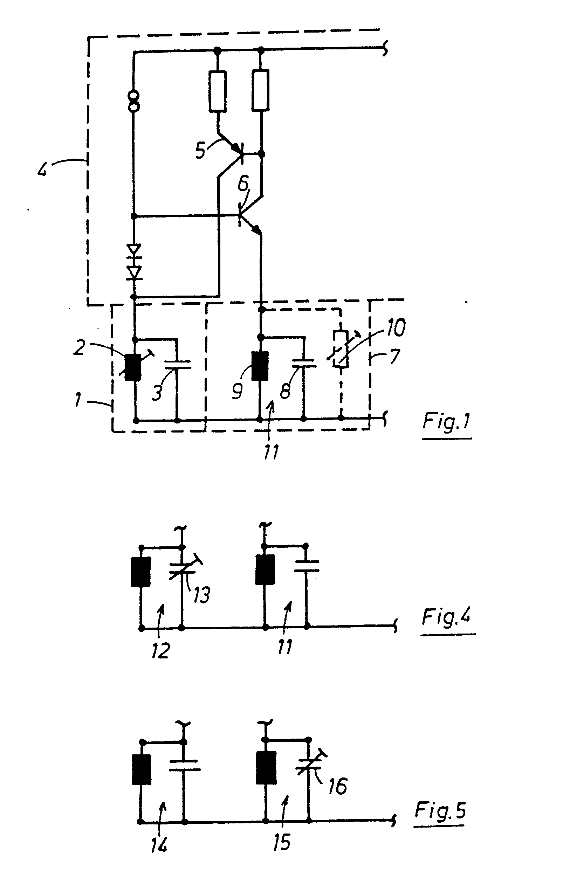

Die in Fig. 1 gezeigte Oszillatorschaltung besteht aus einem frequenzbestimmenden Frequenz-Schwingkreis 1 mit Spule 2 und Kondensator 3, aus einer zweistufigen Verstärkerschaltung 4 mit den beiden Transistoren 5 und 6 und aus einem den Verstärkungsfaktor bestimmenden Impedanzglied 7.

Das Impedanzglied 7 umfaßt einen Kondensator 8 und eine Spule 9, welche die von einem metallischen Auslöser beeinflußbare Sensorspule ist. Das Impedanzglied 7 kann - wie gestrichelt angedeutet ist - noch einen einstellbaren Widerstand 10 aufweisen, der hier parallel zu dem vom Kondensator 8 und der Sensorspule 9 gebildeten Impedanz-Schwingkreis 11 liegt, aber auch in Serie geschaltet werden kann.

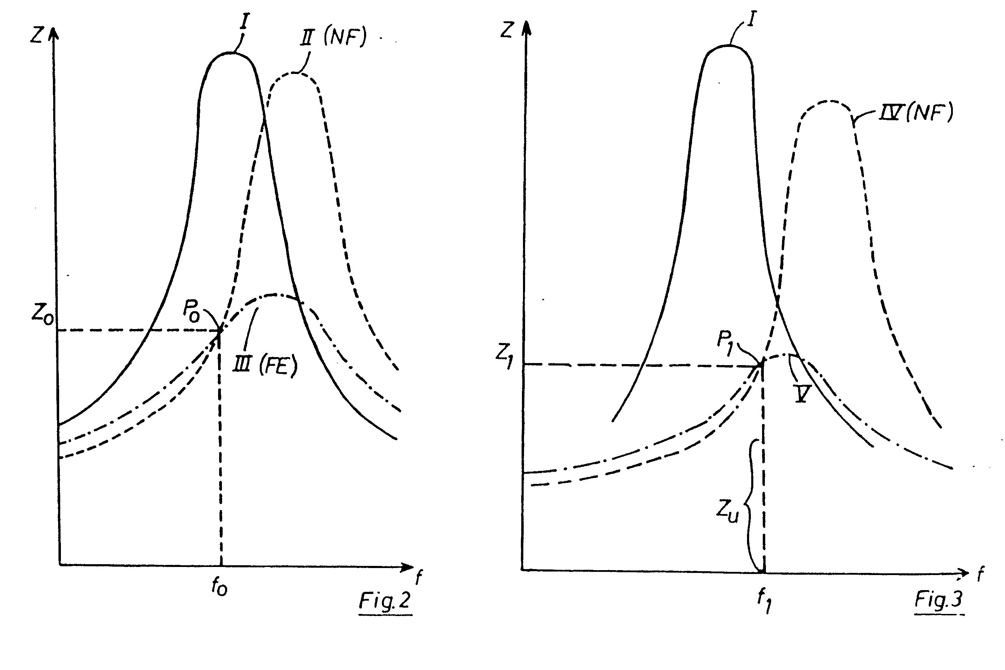

Die Oszillatorschaltung nach Fig. 1 ist derart abgestimmt, daß bei gleichem Abstand eines NF- und eines FE-Auslösers die Impedanz des Impedanz-Schwingkreises 11 auf den kritischen Impedanzwert gebracht ist, bei dessen Überschreiten die Oszillatorschaltung ihren Schwingungszustand wechselt. Zugleich ist die Resonanz-Frequenz des Frequenz-Schwingkreises 1 auf die diesem kritischen Impedanzwert zugehörige Frequenz eingestellt, was nachfolgend anhand der Diagramme nach den Fig. 2 und 3 näher erläutert wird.

In Fig. 2 sind die Impedanz/Frequenz-Kennlinien des Impedanz-Schwingkreises 11 dargestellt, wobei die Kennlinie I den unbeeinflußten Zustand wiedergibt. Die Kennlinie II betrifft den Fall, bei dem ein NF-Auslöser in 20 Millimeter Abstand von der Sensorspule 9 angeordnet ist. Die Kennlinie III betrifft den Fall, bei dem ein FE-Auslöser im Abstand von 20 Millimetern vor der Sensorspule 9 liegt. Wie ersichtlich schneiden sich die Kennlinien II und III in einem Punkt $P_0$, welchem die Koordinaten $f_0$ und $Z_0$ zugehören. Bei der Oszillatorschaltung nach Fig. 1 ist die Spule 2 des Frequenz-Schwingkreises 1 derart eingestellt, daß der Frequenz-Schwingkreis 1 die Resonanz-Frequenz $f_0$ besitzt. Die Impedanz des Impedanzgliedes 7 ist zugleich auf diese kritische Impedanz $Z_0$ eingestellt. Letztere Einstellung kann, wie in Fig. 1 gestrichelt angedeutet ist, beispielsweise mittels des verstellbaren Widerstandes 10 vorgenommen werden. Alternativ kann auch sofort ein Impedanz-Schwingkreis 11 ausgewählt werden, dessen Impedanz bei der Resonanz-Frequenz $f_0$ bereits gleich dem kritischen Impedanzwert $Z_0$ ist. Der Schnittpunkt $P_0$ liegt, bezogen auf die Kennlinie I für den unbeeinflußten Zustand, innerhalb des Bereiches der Kennlinie I, der oberhalb der kritischen Impedanz $Z_0$ liegt und bei dem also der Oszillator des Näherungsschalters bei Nicht-Beeinflussung nicht schwingt. Bei Annäherung eines Metallauslösers auf den gewünschten Schaltabstand von hier 20 Millimetern setzt die Schwingung der Oszillatorschaltung ein, und zwar unabhängig davon, ob ein NF- oder ein FE-Auslöser angenähert wird.

In Fig. 3 sind wiederum die Kennlinie I für den unbeeinflußten Zustand und die Kennlinien IV und V für die Fälle gezeigt, daß einmal ein NF- und zum anderen ein FE-Auslöser in einem Abstand von 15 Millimetern vor der Sensorspule 9 angeordnet ist. Auch hier schneiden sich die Kennlinien IV und V in einem Schnittpunkt $P_1$ mit den Koordinaten $f_1$ und $Z_1$. Wenn also ein Näherungsschalter für einen Schaltabstand von 15 Millimetern hergestellt werden soll, werden bei der Oszillatorschaltung nach Fig. 1 die Eigenfrequenz des Frequenz-Schwingkreises 1 auf diese Frequenz $f_1$ und die Impedanz des Impedanzgliedes 7 auf diesen kritischen Impedanzwert $Z_1$ eingestellt.

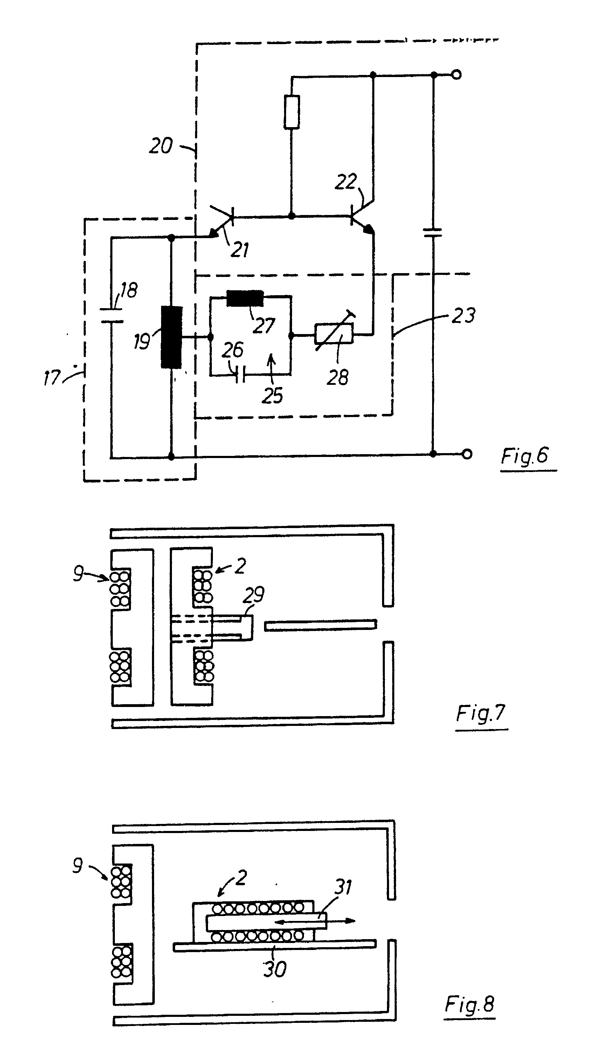

Fig. 4 zeigt als Schaltungsausschnitt den Impedanz-Schwingkreis 11 gemäß Fig. 1 sowie eine abgewandelte Ausführungsform des Frequenz-Schwingkreises 12, bei welchem der Kondensator 13 als Trimmkondensator ausgebildet ist, so daß die Abstimmung auf die Resonanz-Frequenz $f_0$ bzw. $f_1$ am Kondensator 13 vorgenommen ist.

Fig. 5 veranschaulicht eine weitere Abwandlungsmöglichkeit der beiden Schwingkreise. Der frequenzbestimmende Schwingkreis 14 ist hier nicht verstellbar. Dafür weist der Impedanz-Schwingkreis 15 einen Trimmkondensator 16 auf. Hier ist also die Resonanz-Frequenz des Schwingkreises 14 fest vorgegeben, und durch Verstellen des Trimmkondensators 16 wird der Schnittpunkt $P_0$ oder $P_1$ gemäß den Diagrammen nach Fig. 2 und 3 zu dieser vorgegebenen Resonanz-Frequenz hin verschoben.

Fig. 6 zeigt eine alternative Ausführungsform für die Oszillatorschaltung, welche hier ebenfalls aus einem frequenzbestimmenden Parallelschwingkreis 17 mit Kondensator 18 und Spule 19, einer Verstärkerschaltung 20 mit den beiden Transistoren 21, 22 und aus einem Impedanzglied 23 besteht. Das Impedanzglied 23 besteht aus einem Impedanz-Parallelschwingkreis 25 mit Kondensator 26 und Spule 27 und aus einem mit dem Impedanz-Schwingkreis 25 in Reihe geschalteten, verstellbaren Widerstand 28. Das Impedanzglied 23 ist an eine Mittelanzapfung der Spule 19 angeschlossen. Die Spule 27 des Impedanz-Schwingkreises 25 bildet hier die durch einen äußeren Auslöser beeinflußbare Sensorspule.

In Fig. 7 ist die Ausbildung der Sensorspule 9 des Impedanz-Schwingkreises 11 und der Spule 2 des Frequenz-Schwingkreises 1 nach Fig. 1 gegenständlich dargestellt. Beide Spulen weisen gleichen Schalenkern auf und sind mechanisch im wesentlichen gleich ausgebildet. Bei der Spule 2 ist ein verstellbarer Schraubkern 29 vorgesehen.

Beim Ausführungsbeispiel nach Fig. 8 ist die Spule 2 des frequenzbestimmenden Schwingkreises 1 auf einer Leiterplatte 30 angeordnet. Die Spule besitzt einen mehr oder weniger weit einführbaren Tauchkern 31, mit welchem die Abstimmung vorgenommen wird.

Bei allen gezeigten Ausführungsbeispielen bestehen die Frequenz- und Impedanz-Schwingkreise jeweils aus Parallel-Schwingkreisen. Es ist aber auch möglich, diese Schwingkreise als Serienschwingkreise auszubilden.

## Patentansprüche

1. Induktiver Näherungsschalter, bestehend aus einer Oszillatorschaltung mit einem im wesentlichen die Frequenz bestimmenden Frequenz-Schwingkreis (1) und mit einem im wesentlichen die Verstärkung bzw. den Grad der Rückkopplung bestimmenden Impedanzglied (7), welches einen Impedanz-Schwingkreis (11) mit einer durch die Annäherung eines metallischen Auslösers beeinflußbaren Sensorspule (9) enthält, und aus einer Auswerteschaltung, die die Schaltzustände des Näherungsschalters aus dem Schwingungszustand, d.h. dem Vorhandensein oder Nichtvorhandensein einer Schwingung ableitet, wobei bei einem kritischen, dem Schaltabstand des Auslösers zugeordneten Impedanzwert des Impedanzgliedes, d.h. bei einem kritischen Verstärkungsfaktor, der Schwingungszustand des Oszillators wechselt, dadurch gekennzeichnet, daß die Resonanz-Frequenz ($f_0$) des Frequenz-Schwingkreises (1) und der kritische Impedanzwert ($Z_0$) des Impedanzgliedes (7) den Koordinaten ($f_0$, $Z_0$) des Schnittpunktes ($P_0$) der beiden Impedanz/Frequenz-Kennlinien (II, III) entsprechen, die das Impedanzglied (7) für Nichteisen (NF)- und Eisen (FE)-Metalle bei jeweils gleichem Schaltabstand aufweist.

2. Näherungsschalter nach Anspruch 1, dadurch gekennzeichnet, daß der Frequenz-Schwingkreis (1) und der Impedanz-Schwingkreis (11) eine hohe Güte, z.B. von 100, besitzen.

3. Näherungsschalter nach den Ansprüchen 1 und 2, dadurch gekennzeichnet, daß der Frequenz-Schwingkreis (1) und der Impedanz-Schwingkreis (11) aus gleichen Bauteilen bestehen und mechanisch identisch ausgeführt sind.

4. Näherungsschalter nach einem der Ansprüche 1 bis 3, dadurch gekennzeichnet, daß der Frequenz-Schwingkreis (1) und der Impedanz-Schwingkreis (11) jeweils Parallel-Schwingkreise sind.

5. Näherungsschalter nach Anspruch 1, dadurch gekennzeichnet, daß die Induktivität der Spule (2) des Frequenz-Schwingkreises (1) einstellbar ist.

6. Näherungsschalter nach Anspruch 1, dadurch gekennzeichnet, daß die Kapazität des Kondensators (13) des Frequenz-Schwingkreises (12) einstellbar ist.

7. Näherungsschalter nach Anspruch 1, dadurch gekennzeichnet, daß die Kapazität des Kondensators (16) des Impedanz-Schwingkreises (15) einstellbar ist.

8. Näherungsschalter nach Anspruch 1, dadurch gekennzeichnet, daß das Impedanzglied (7) einen einstellbaren Widerstand (10) aufweist.

## Claims

1. Inductive proximity switch, consisting of an oscillator circuit with a frequency resonant circuit (1) essentially determining the frequency and with an impedance device (7), essentially determining the amplification respective the degree of back-coupling, which contains an impedance resonant circuit (11) with a sensor coil (9) sensitive to the approach of a metal trigger, and (consisting) of an evaluation circuit, which deduces the switching states of the proximity switch from the state of oscillation, i. e. from the presence or absence of oscillation, in which the oscillation state of the oscillator changes at a critical impedance value of the impedance device adjusted to the switching distance of the trigger, i. e. when a critical amplification factor is reached, characterised in that the resonance frequency ($f_0$) of the frequency resonant circuit (1) and the critical impedance value ($Z_0$) of the impedance device (7) correspond to the coordinates ($f_0$, $Z_0$) of the intersection point ($P_0$) of the two impedance-frequency parabolas (II, III) which the impedance device (7) displays for non-ferrous (NF) and ferrous (FE) metals at the same switching distance.

2.   Proximity switch according to Claim 1, characterised in that the frequency resonant circuit (1) and the impedance resonant circuit (11) have a high quality factor, for example 100.

3.   Proximity switch according to Claims 1 and 2, characterised in that the frequency resonant circuit (1) and the impedance resonant circuit (11) consist of the same components and are identical in mechanical construction.

4.   Proximity switch according to one of Claims 1 to 3, characterised in that the frequency resonant circuit (1) and the impedance resonant circuit (11) are each a parallel resonant circuit.

5.   Proximity switch according to Claim 1, characterised in that the inductivity of the coil (2) of the frequency resonant circuit (1) is adjustable.

6.   Proximity switch according to Claim 1, characterised in that the capacity of the capacitor (13) of the frequency resonant circuit (12) is adjustable.

7.   Proximity switch according to Claim 1, characterised in that the capacity of the capacitor (16) of the impedance resonant circuit (15) is adjustable.

8.   Proximity switch according to Claim 1, characterised in that the impedance device (7) has an adjustable resistor (10).

**Revendications**

1.   Commutateur de proximité inductif, composé, d'une part, d'un circuit oscillateur avec un circuit oscillant en fréquence (1), déterminant essentiellement la fréquence, et avec un organe à impédance (7) déterminant essentiellement l'amplification, respectivement le degré de réaction, qui contient un circuit oscillant à impédance (11) avec une bobine de capteur (9) influençable par l'approche d'un déclencheur métallique, et composé, d'autre part, d'un circuit d'exploitation, qui dérive les états de commutation du commutateur de proximité à partir de l'état d'oscillation, c'est-à-dire de la présence ou de l'absence d'une oscillation, l'état d'oscillation de l'oscillateur étant modifié pour une valeur d'impédance critique, associée à la distance de commutation du déclencheur, de l'organe à impédance, c'est-à-dire pour un facteur d'amplification critique, caractérisé en ce que la fréquence de résonance ($f_0$) du circuit oscillateur de fréquence (1) et la valeur d'impédance critique ($Z_0$) de l'organe d'impédance (7) correspondent aux coordonnées ($f_0$, $Z_0$) du point d'intersection ($P_0$) des deux caractéristiques impédance/fréquence (II,III), que présente l'organe à impédance (7), pour des métaux non-ferreux (NF) et ferreux (FE), chaque fois pour la même distance de commutation.

2.   Commutateur de proximité inductif selon la revendication 1, caractérisé en ce que le circuit oscillant de fréquence (1) et le circuit oscillant à impédance (11) présentent un facteur de qualité identique, par exemple de 100.

3.   Commutateur de proximité inductif selon les revendications 1 et 2, caractérisé en ce que le circuit oscillant de fréquence (1) et le circuit oscillant à impédance (11) se composent des mêmes composants et sont de réalisation mécaniquement identique.

4.   Commutateur de proximité inductif selon l'une des revendications 1 à 3, caractérisé en ce que le circuit oscillant de fréquence (1) et le circuit oscillant à impédance (11) sont chacun des circuits oscillants parallèles..

5.   Commutateur de proximité inductif selon la revendication 1, caractérisé en ce que l'inductivité de la bobine (2) du circuit oscillant de fréquence (1) est réglable.

6.   Commutateur de proximité inductif selon la revendication 1, caractérisé en ce que la capacité du condensateur (13) du circuit oscillant de fréquence (12) est réglable.

7. Commutateur de proximité inductif selon la revendication 1, caractérisé en ce que la capacité du condensateur (16) du circuit oscillant d'impédance (15) est réglable.

8. Commutateur de proximité inductif selon la revendication 1, caractérisé en ce que l'organe d'impédance (7) présente une résistance (10) réglable.

*Fig.1*

*Fig.4*

*Fig.5*

Fig.2

Fig.3

EP 0 288 921 B1

*Fig.6*

*Fig.7*

*Fig.8*